# FASCICULE DE BREVET EUROPEEN

(11) **EP 0 449 674 B1**
(45) Date de publication et mention de la délivrance du brevet: **14.09.1994**
(21) Numéro de dépôt: 91400376.9
(22) Date de dépôt: 14.02.1991
(51) Int. Cl.: H01H 13/70

(54) **Dispositif interrupteur miniature a effet tactile**
Miniaturschalter mit Berührungseffekt
Miniature tactile effect switch

(30) Priorité: 30.03.1990 FR 9004065
(43) Date de publication de la demande: 02.10.1991
(73) Titulaire: SEXTANT AVIONIQUE, F-92366 Meudon la Forêt Cédex (FR)
(72) Inventeur: Bedoya, Claude, F-78180 Montigny Le Bretonneux (FR)
(74) Mandataire: de Saint-Palais, Arnaud Marie

(56) Documents cités:
- EP-A- 0 100 875
- US-A- 4 083 100
- US-A- 4 468 542

## Description

La présente invention concerne un dispositif interrupteur miniature à effet tactile pouvant s'intégrer à un circuit imprimé, notamment en vue de la réalisation d'un clavier à touches ultra-plat.

D'une manière générale, on sait qu'on a déjà proposé, notamment par les brevets US-A-4 083 100, US-A-4 468 542 et EP-A-0 100 875, des dispositifs interrupteurs réalisant des contacts électriques entre des plages conductrices du circuit imprimé par déformation élastique de capsules métalliques en forme de calottes.

Habituellement, chacune de ces capsules est placée sur le circuit imprimé de manière à être en contact électrique par sa périphérie avec une première plage conductrice et à s'étendre au-dessus d'une seconde plage conductrice électriquement isolée de la première et placée sensiblement en regard de la zone centrale de la capsule, cette seconde plage conductrice pouvant consister en un perçage métallisé de type classique.

La connexion de la capsule sur le circuit imprimé est alors assurée par trois plots agissant en trois points de sa périphérie, à 120° l'un de l'autre (cf. US-A-4 083 100).

Il est clair qu'en exerçant sur la capsule une pression orientée vers le circuit imprimé, on provoque une déformation de cette capsule jusqu'à ce que sa partie centrale vienne en butée fin de course sur la seconde plage conductrice en établissant sa liaison électrique avec la première plage conductrice.

Il s'avère que ces dispositifs ne produisent pas un effet tactile du type de celui habituellement recherché dans les interrupteurs de ce genre. En effet, l'effort résistant qu'oppose la capsule à une sollicitation s'accroît d'une façon continue jusqu'à ce qu'il compense exactement cette sollicitation, lorsque la partie centrale de la capsule vient en butée fin de course sur la seconde plage conductrice.

C'est la raison pour laquelle ces dispositifs exigent l'emploi, dans la liaison située entre la capsule et la touche qui lui est habituellement associée, de moyens relativement complexes, délicats à réaliser et, par conséquent, coûteux, qui sont destinés à produire l'effet tactile recherché.

L'usage de ces moyens présente en outre l'inconvénient d'augmenter de façon notable l'épaisseur du clavier, ce qui est contraire au résultat recherché.

L'invention a donc pour but de supprimer ces inconvénients. Elle propose un dispositif interrupteur d'un type similaire à celui précédemment décrit qui produit un effet tactile sans avoir à utiliser des moyens particuliers dans la liaison entre capsule et poussoir, et qui permet de réduire l'épaisseur totale (circuit imprimé, calotte, touche) du clavier.

Elle a en outre pour but la réalisation d'un dispositif interrupteur présentant les avantages suivants :
- pas de rebond,
- meilleure qualité du contact électrique,
- durée de vie accrue.

Elle propose un dispositif interrupteur faisant intervenir, comme précédemment mentionné, un circuit imprimé présentant au moins deux plages conductrices et une capsule en forme de calotte sensiblement sphérique maintenue sur le circuit imprimé de manière à ce qu'elle soit en contact électrique, par sa périphérie, avec la première plage conductrice, tandis qu'elle s'étend au-dessus de la seconde plage conductrice, la seconde plage conductrice présentant une forme annulaire sensiblement coaxiale à ladite capsule et bordant une cavité réalisée dans ledit circuit imprimé.

Selon l'invention, ce dispositif est caractérisé en ce que les dimensions de la capsule et celles du perçage sont déterminées de manière à ce que, sous l'effet d'une sollicitation, la partie centrale de la capsule, après avoir subi une inversion de concavité puisse s'engager dans ladite cavité centrale.

Avantageusement, le rapport entre la base circulaire de la capsule et le diamètre de la cavité est voisin ou égal à 3.

Un mode d'exécution de l'invention sera décrit ci-après, à titre d'exemple non limitatif, avec référence aux dessins annexés dans lesquels :
La figure 1 est une coupe transversale schématique d'un dispositif interrupteur selon l'invention ;
La figure 2 est une vue partielle de dessus du circuit imprimé utilisé dans l'interrupteur représenté figure 1, dans une zone comprenant un lamage au fond duquel sont disposés les contacts de l'interrupteur ;
Les figures 3, 4 et 5 sont des coupes transversales schématiques montrant un interrupteur à l'état de repos (figure 3), à l'état fin de course de fermeture (figure 4) et à l'état fin de surcourse (figure 5).

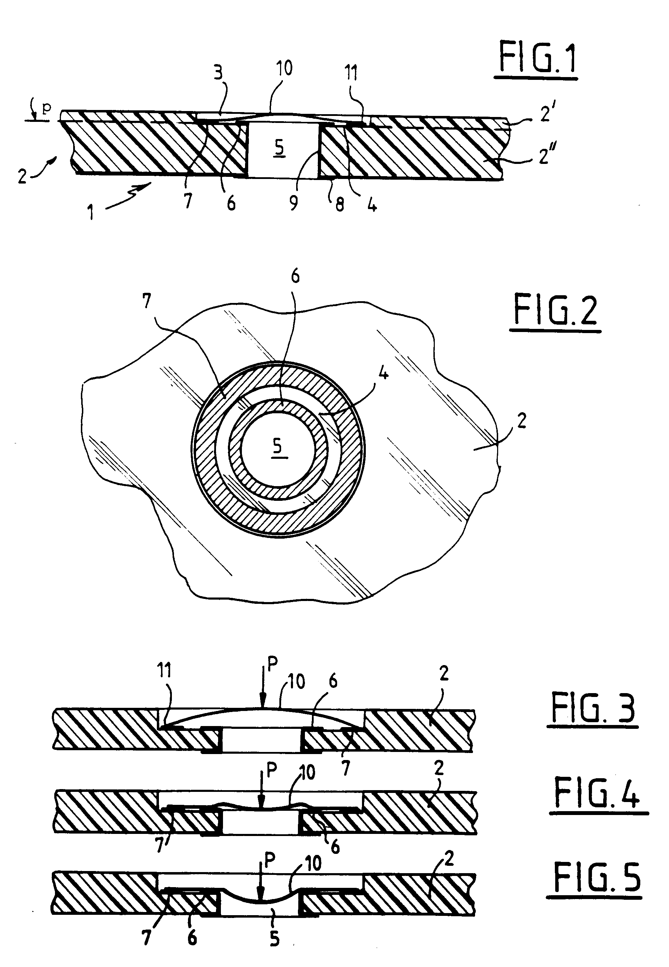

Tel que représenté sur les figures 1 et 2, le dispositif interrupteur 1 est intégré à un circuit imprimé 2 comprenant un lamage cylindrique 3 (cavité borgne) dont le fond 4 est muni d'un perçage central coaxial traversant 5.

Le fond 4 porte deux métallisations annulaires coaxiales 6, 7 qui constituent les deux contacts fixes de l'interrupteur que l'on souhaite relier électriquement à la demande, à savoir :
- une métallisation annulaire 7 sensiblement adjacente à la paroi cylindrique du lamage 3, et
- une métallisation annulaire 6 bordant le perçage central 5.

Bien entendu, ces métallisations 6, 7 sont destinées à être reliées à des circuits électriques et/ou électroniques, éventuellement portés par le circuit imprimé 2, par des liaisons conductrices non représentées.

Dans cet exemple, la métallisation 6 est électriquement reliée à une plage conductrice 8 portée par la face inférieure du circuit imprimé 2 grâce à une métallisation 9 de la paroi cylindrique du perçage central 5.

Avantageusement, le circuit imprimé 2 pourra être réalisé par une superposition de deux plaquettes de circuit imprimé double face 2′, 2˝ fixées l'une à l'autre, au niveau du plan p indiqué sur la figure 1 en traits interrompus, l'une de ces plaquettes 2′ présentant le (ou les) évidement(s) correspondant au(x) lamage(s) 3, tandis que la plaquette 2˝ est munie du (ou des) perçage(s) traversant(s) 5.

L'organe destiné à assurer une liaison électrique commandable entre les deux contacts annulaires consiste en une capsule métallique 10 élastiquement déformable en forme de calotte sensiblement sphérique dont la base circulaire 11 présente un diamètre sensiblement égal au diamètre du lamage 3. De préférence, la hauteur de cette capsule 10 est, au plus, égale à celle du lamage 3, de manière à réduire autant que possible l'épaisseur de l'interrupteur.

Comme on peut le voir sur les figures 1 et 3, au repos, la capsule 10 disposée dans le lamage 3 porte, par sa bordure périphérique 11, sur la plage métallisée annulaire 7, tandis que sa partie centrale s'étend au-dessus de la métallisation 6. Dans cette position, les deux métallisations 6, 7 sont électriquement isolées l'une de l'autre.

A partir de cette position, une pression P exercée sur le sommet de la capsule 10, en direction de la plage métallique 6 va provoquer une déformation élastique de la capsule 10 qui, dans un premier temps (course de fermeture) va engendrer un effort résistant croissant en fonction de l'amplitude de la déformation.

A la fin de cette course de fermeture, la capsule 10 vient s'appliquer sur la plage annulaire 6 en établissant ainsi un contact électrique entre les deux plages 6, 7.

La qualité de ce contact est accrue grâce au fait que la calotte vient porter sur l'arête circulaire de la métallisation (contact circulaire).

Simultanément, la déformation de la capsule 10 atteint un point critique (figure 4) à partir duquel s'amorce une inversion de concavité de la partie centrale de la capsule 10 avec un effet de relâchement de l'effort résistant.

Cette inversion de concavité est rendue possible grâce à la présence du perçage 5 dans lequel vient s'étendre la partie centrale de la calotte.

En fin d'inversion, l'effort appliqué n'engendre plus de déformation notable de la capsule 10 et est donc compensé par l'effort résistant.

Dès que cesse toute sollicitation, la capsule 10 retourne automatiquement à sa position de repos représentée figures 1 et 3.

Des essais effectués sur un interrupteur présentant un lamage de diamètre ⌀1 = 7 mm, un perçage traversant de diamètre ⌀ = 2,5 mm (rapport diamètre de la base circulaire de la calotte/diamètre du perçage voisin de 3) et une capsule du type de celles commercialisées sous la marque "SECME" ont permis d'obtenir d'excellents résultats, avec un dépassement du sommet de la calotte par rapport au plan p de l'ordre de 0,055 mm.

Ces essais ont permis de faire apparaître les avantages suivants :
- pas de rebond,
- meilleure qualité du contact (circulaire) relativement au contact (ponctuel) des solutions existantes,
- durée de vie accrue (supérieure à 5.10⁶ manoeuvres), et
- facilité de montage, en particulier du positionnement de la capsule.

Bien entendu, à ces avantages s'ajoute celui qui résulte du fait que l'épaisseur totale de l'interrupteur ne dépasse pas celle du circuit imprimé 2.

L'interrupteur précédemment décrit, qui peut être actionné par un bouton-poussoir classique, peut être utilisé unitairement ou même en combinaison avec d'autres interrupteurs du même genre, par exemple en vue de réaliser un clavier.

Dans ce dernier cas, les différents interrupteurs sont réalisés, selon une configuration matricielle, sur une même plaque de circuit imprimé.

## Revendications

1. Dispositif interrupteur à effet tactile du type comprenant un circuit imprimé portant au moins deux plages conductrices (6, 7) coopérant avec une capsule en forme de calotte sphérique (10) réalisée en un matériau électriquement conducteur et élastiquement déformable, cette capsule (10) étant maintenue en contact électrique, par sa périphérie avec la première plage conductrice (7) et s'étendant, au repos, au-dessus de la seconde plage conductrice (6), la susdite seconde plage conductrice (6) présentant une forme annulaire sensiblement coaxiale à ladite capsule et bordant une cavité centrale (5) réalisée dans ledit circuit imprimé (2),
caractérisé en ce que les dimensions de la capsule et celles du perçage sont déterminées de manière à ce que, sous l'effet d'une sollicitation, la partie centrale de la capsule, après avoir subi une inversion de concavité, puisse s'engager dans ladite cavité centrale.

2. Dispositif selon la revendication 1,
caractérisé en ce que le rapport entre la base circulaire de la capsule (10) et le diamètre de la cavité (3) est voisin ou égal à 3.

3. Dispositif selon la revendication 1,
caractérisé en ce que la susdite première plage conductrice (7) présente une forme annulaire coaxiale à la seconde plage (6).

4. Dispositif selon l'une des revendications 1 et 2,
caractérisé en ce que les deux plages annulaires (6, 7) sont placées dans le fond (4) d'une cavité cylindrique (3) réalisée dans le circuit imprimé (2), qui présente un diamètre sensiblement égal à celui du bord périphérique (11) de la capsule (10).

5. Dispositif selon la revendication 4,
caractérisé en ce que la hauteur de la capsule (10) est au plus égale à la profondeur de la susdite cavité cylindrique (3).

6. Dispositif selon l'une des revendications précédentes,
caractérisé en ce que le rapport diamètre de la cavité (3) cylindrique/diamètre du perçage (5) est voisin ou égal à 3.

7. Dispositif selon l'une des revendications précédentes,
caractérisé en ce que le circuit imprimé consiste en la superposition de deux plaquettes de circuit imprimé (2′, 2˝) dont l'une présente au moins un évidement correspondant à la cavité cylindrique (3) et dont l'autre comprend un perçage traversant (5) placé coaxialement à ladite cavité (3).

## Patentansprüche

1. Miniaturschalter mit Berührungseffekt von der Art mit einer gedruckten Schaltung mit wenigstens zwei leitenden Bereichen (6, 7), die mit einer kalottenförmigen Kappe (10) aus einem elektrisch leitenden und elastisch verformbaren Material zusammenwirken, wobei besagte Kappe (10) durch ihre Peripherie mit dem ersten leitenden Bereich (7) Kontakt hat und sich in Ruhestellung über dem zweiten leitenden Bereich (6) erstreckt und der besagte zweite leitende Bereich (6) ringförmig und im wesentlichen koaxial zur besagten Kappe ist und eine zentrale, in besagter gedruckter Schaltung (2) vorgesehe Bohrung (5) umgibt,
dadurch gekennzeichnet, dass die Ausmasse der Kappe und die der Bohrung so bestimmt sind, dass bei Beaufschlagung der zentrale Teil der Kappe, nachdem seine Konkavität umgekehrt wurde, in besagte zentrale Bohrung eindringen kann.

2. Vorrichtung nach Anspruch 1,
dadurch gekennzeichnet, dass das Verhältnis zwischen der kreisförmigen Basis der Kappe (10) und dem Durchmesser der Bohrung (5) etwa 3 oder gleich 3 ist.

3. Vorrichtung nach Anspruch 1,
dadurch gekennzeichnet, dass der besagte erste leitende Bereich (7) ringförmig und koaxial zum zweiten Bereich (6) ist.

4. Vorrichtung nach einem der Ansprüche 1 und 2,
dadurch gekennzeichnet, dass die beiden ringförmigen Bereiche (6, 7) auf dem Boden (4) einer zylindrischen, im Schaltkreis der gedruckten Schaltung (2) vorgesehenen, Vertiefung (3) angeordnet sind, deren Durchmesser etwa gleich dem des Aussenrandes (11) der Kappe (10) ist.

5. Vorrichtung nach Anspruch 4,
dadurch gekennzeichnet, dass die Höhe der Kappe (10) höchstens gleich der Tiefe der besagten zylindrischen Vertiefung (3) ist.

6. Vorrichtung nach einem der vorhergehenden Ansprüche,
dadurch gekennzeichnet, dass das Verhältnis des Durchmessers der zylindrischen Vertiefung (3) zum Durchmesser der Bohrung (5) etwa drei oder gleich drei ist.

7. Vorrichtung nach einem der vorhergehenden Ansprüche,
dadurch gekennzeichnet, dass die gedruckte Schaltung aus der Übereinanderanordnung von zwei gedruckten Schaltplättchen (2′, 2˝) besteht, deren eines mindestens eine der zylindrischen Vertiefung (3) entsprechende Aussparung aufweist und deren anderes eine durchgehende Bohrung (5) koaxial zur besagten Vertiefung (3) aufweist.

## Claims

1. A switch device with tactile effect of the type comprising a printed circuit carrying at least two conducting areas (6, 7), cooperating with a cap (10) in the form of a spherical skull cap made from an electrically conducting and resiliently deformable material, this cap (10) being maintained in electric contact, by its periphery, with the first conducting area (7) and extending, at rest, above the second conducting area (6), said second conducting area (6) having an annular shape substantially coaxial with said cap and bordering a central cavity (5) formed in said printed circuit (2),
characterized in that the dimensions of the cap and those of the bore are determined so that, under the effect of an operating force, the central portion of the cap, after undergoing a reversal of concavity, may be engaged in said central cavity.

2. The device as claimed in claim 1,
characterized in that the ratio between the circular base of the cap (10) and the diameter of the cavity (3) is close or equal to 3.

3. The device as claimed in claim 1,
characterized in that said first conducting area (7) has an annular shape coaxial with the second area (6).

4. The device as claimed in one of claims 1 and 2,
characterized in that the two annular areas (6, 7) are placed in the bottom (4) of a cylindrical cavity (3) formed in the printed circuit (2) which has a diameter substantially equal to that of the peripheral edge (11) of the cap (10).

5. The device as claimed in claim 4,
characterized in that the height of the cap (10) is at most equal to the depth of said cylindrical cavity (3).

6. The device as claimed in one of the preceding claims,
characterized in that the ratio between the diameter of the cylindrical cavity (3) and the diameter of the bore (5) is close or equal to 3.

7. The device as claimed in one of the preceding claims,
characterized in that the printed circuit consists of the superimposition of two printed circuit wafers (2′, 2˝), one of which has at least one recess corresponding to the cylindrical cavity (3) and the other comprises a throughbore (5) placed coaxially to said cavity (3).
